# EUROPÄISCHE PATENTSCHRIFT

(11) **EP 2 702 567 B1**
(45) Veröffentlichungstag und Bekanntmachung des Hinweises auf die Patenterteilung: **04.10.2017**
(21) Anmeldenummer: 12706552.2
(22) Anmeldetag: 27.02.2012
(51) Int. Cl.: G05G 1/02, H05K 5/00, G07C 9/00

(54) **MOBILE VORRICHTUNG, BEI DER DAS INNENLIEGENDE SCHALTELEMENT DURCH DAS GEHÄUSE GESCHÜTZT IST**
MOBILE DEVICE IN WHICH THE INTERIOR SWITCH ELEMENT IS PROTECTED BY THE HOUSING
DISPOSITIF MOBILE AVEC LEQUEL L'ÉLÉMENT DE COMMANDE LOGÉ À L'INTÉRIEUR EST PROTÉGÉ PAR LE BOÎTIER

(30) Priorität: 27.04.2011 DE 102011002286
(43) Veröffentlichungstag der Anmeldung: 05.03.2014
(73) Patentinhaber: Huf Hülsbeck & Fürst GmbH & Co. KG, 42551 Velbert (DE)
(72) Erfinder: SERSCH, Jürgen, 42659 Solingen (DE)
(74) Vertreter: Vogel, Andreas
(86) Internationale Anmeldenummer: PCT/EP2012/053258
(87) Internationale Veröffentlichungsnummer: WO 2012/146407

(56) Entgegenhaltungen:
- DE-A1- 10 131 500
- DE-A1-102005 014 563
- DE-A1-102008 025 033
- DE-C1- 19 964 166
- US-A1- 2002 125 112

## Beschreibung

Die Erfindung betrifft eine mobile Vorrichtung zur Aktivierung mindestens eines Schaltelementes, das innerhalb eines Gehäuses angeordnet ist, mit einer Tasteneinheit, die mindestens ein Kontaktmittel aufweist, wobei das Kontaktmittel zum Innern des Gehäuses ausgerichtet ist, um das Schaltelement zu aktivieren, und einer an dem Gehäuse angeordneten Aufnahme, an der die Tasteneinheit befestigt ist.

Aus der DE 101 21 045 C2 ist ein ID-Geber offenbart, in dem ein Tastenfeld innerhalb eines Gehäuses befestigt ist. Am Tastenfeld ist ein Stößel angeformt. Dieser Stößel dient bei Betätigung zur Aktivierung eines Schaltelementes, in dem die elastische Taste mit dem Stößel gegen das Schaltelement bewegt wird. Das Tastenfeld ist an einem Rand eines Trägers befestigt. Der Träger weist Rastelemente auf, die zur Befestigung am Gehäuse dienen. Der ID-Geber zeigt sich vorteilhafterweise dadurch aus, dass er sicher und leicht montierbar ist, wobei gleichzeitig eine sichere Abdichtung erzielt wird, da das Tastenfeld mit dem Träger die Gehäuseöffnung vollständig verschließt. Auch die DE 199 64 166 C1 zeigt ein Gehäuse für einen ID-Geber, in dem eine Tasteneinheit befestigt ist, wobei die Tasteneinheit ein Kontaktmittel aufweist.

Es ist Aufgabe der vorliegenden Erfindung, eine mobile Vorrichtung zu schaffen, bei der der Aufwand bei der Fertigung und/oder bei der Montage weiter reduziert wird, wobei gleichzeitig eine sichere Abdichtung, insbesondere am Gehäusebereich der Tasteneinheit gewährleistet ist.

Zur Lösung dieser Aufgabe wird eine mobile Vorrichtung mit sämtlichen Merkmalen des Anspruches 1 gelöst. In den abhängigen Ansprüchen sind mögliche Ausführungsformen der Erfindung beschrieben.

Erfindungsgemäß ist vorgesehen, dass die Aufnahme einen Kraftübertragungsbereich aufweist, der zwischen der Tasteneinheit und dem Schaltelement derart angeordnet ist, dass das Innere des Gehäuses vom Außenbereich geschützt ist. Wenn die Tasteneinheit von außen durch den Benutzer aktiviert wird, insbesondere wenn der Benutzer auf die Tasteneinheit drückt, erfolgt eine entsprechende Bewegung des Kontaktmittels in Richtung des Inneren des Gehäuses, wobei gleichzeitig das Kontaktmittel auf den Kraftübertragungsbereich wirkt. Der Kraftübertragungsbereich wird somit kurzzeitig in Richtung des im Inneren des Gehäuses sich befindenden mindestens einem Schaltelement verformt, insbesondere elastisch und/oder flexibel verformt, wodurch eine entsprechende Kontaktierung des Schaltelementes entsteht. Da das Kraftübertragungselement den Inneren Bereich des Gehäuses vom Außenbereich der mobilen Vorrichtung vollständig trennt, ist es ausgeschlossen, dass im Bereich des Gehäuses, in dem die Tasteneinheit sich befindet, Feuchtigkeit, Schmutzpartikel, etc. in das Innere der mobilen Vorrichtung eindringen können. Somit kann die in der Regel innerhalb der mobilen Vorrichtung sich befindende Elektronik, einschließlich Platine, Schaltelemente, Sensoren, Batterie, etc. einfach und wirkungsvoll zum Außenbereich abgedichtet sein, wobei gleichzeitig die Montage der Tasteneinheit in die Aufnahme vereinfacht ist, da die Befestigung der Tasteneinheit vollständig im Außenbereich der mobilen Vorrichtung liegt und somit keine besonders hohen Anforderungen zur Befestigung der Tasteneinheit am Gehäuse bestehen, um die Abdichtung des Inneren des Gehäuses zu gewährleisten.

In einer möglichen Ausführungsform der Erfindung kann das Gehäuse und der Kraftübertragungsbereich ein gemeinsames, Zweikomponenten-Bauteil bilden. Der Kraftübertragungsbereich befindet sich zumindest bereichsweise in der Aufnahme des Gehäuses. Bei dieser Ausgestaltung der Erfindung bildet vorteilhafterweise das Gehäuse und der Kraftübertragungsbereich ein monolithisches Bauteil, sodass das Innere des Gehäuses vollständig durch das monolithische Bauteil vom Außenbereich der mobilen Vorrichtung getrennt ist. Das Zweikomponenten-Bauteil kapselt somit den Innenbereich der mobilen Vorrichtung, der unter Anderem elektronische Komponenten umfasst, vollständig ab. Hierdurch kann eine zuverlässige Abdichtung erzielt werden.

Eine vorteilhafte Ausgestaltung der Erfindung kann sein, dass der Kraftübertragungsbereich aus einem ersten Material ausgeführt ist und das Gehäuse aus einem zweiten Material ausgeführt ist, wobei das erste Material einen geringeren mechanischen Widerstand hat als das zweite Material. Das erste Material und/oder das zweite Material können Kunststoffgemische sein. In einer vorteilhaften Ausführung der mobilen Vorrichtung kann das erste Material ein Silikon oder ein thermoplastisches Polymer sein. Der Kraftübertragungsbereich der Aufnahme kann zum Beispiel aus einem thermoplastischen Elastomer (TPE) oder einem thermoplastischen Elastomer auf Urethanbasis (TPU) ausgeführt sein.

Die Tasteneinheit ist zumindest durch ein flexibles und/oder elastisches Tastenelement und einem Träger gebildet, der zumindest teilweise durch das flexible Tastenelement umfasst ist. Hierbei umfasst die Tasteneinheit mindestens zwei Bauteile, die sich aus dem Träger und dem Tastenelement zusammensetzen. Das Tastenelement wiederum kann eine Mehrzahl an Einzeltasten umfassen, insbesondere ein Feld von Einzeltasten aufweisen. Vorteilhafterweise ist jeder Einzeltaste ein Kontaktmittel zugeordnet, welches wiederum mit jeweils einem Schaltelement kommuniziert bzw. welches bei einer entsprechenden Betätigung des Benutzers auf der Tasteneinheit auf dem jeweiligen Schaltelement wirkt. Der Träger ist vorteilhafterweise eine Art Rahmen für das Tastenelement, wobei zum Außenbereich hin das Tastenelement den Träger vollständig umspannt und bedeckt, sodass der Träger nicht für den Benutzer sichtbar in der Aufnahme des Gehäuses befestigt ist.

Vorteilhaft kann sein, dass das Tastenelement am Träger aufgespannt ist, insbesondere dass das Tastenelement strumpfartig am Träger aufgezogen und/oder aufgestülpt ist. Bei der Aufbringung des flexiblen Tastenelementes wird das Material des Tastenelementes derart gedehnt, damit das Tastenelement vollständig die Geometrie des Trägers umfassen kann. Im aufgesetzten Zustand ist das Tastenelement gespannt auf den Träger, wobei die Innenseite des Tastenelementes die Oberfläche des Trägers kontaktiert. In einer möglichen Ausführungsform der Erfindung ist der innenliegende Bereich des Trägers, der dem Außenbereich der mobilen Vorrichtung abgewandt ist, zumindest bereichsweise nicht vom Tastenelement umfasst. Das bedeutet, dass an zumindest einem Teilbereich des Trägers, der dem Kraftübertragungsbereich zugewandt ist, das Tastenelement nicht angreift. Dieser Teilbereich ist somit tastenelementfrei ausgeführt.

Zudem kann vorteilhaft vorgesehen sein, dass das Tastenelement mit mindestens einem Kontaktmittel ausgeführt ist, das durch einen Durchbruch des Trägers sich erstreckt, wobei insbesondere mehrere Kontaktmittel vorgesehen sind, die durch jeweils unterschiedliche Durchbrüche des Trägers sich erstrecken. Der Durchbruch bzw. die Durchbrüche können unterschiedliche Geometrieformen annehmen, beispielsweise rund, quadratisch, eckig, vieleckig ausgeführt sein. Das Kontaktmittel ist zweckmäßigerweise der geometrischen Form des Durchbruches angepasst, wobei in einer möglichen Ausführungsform der Erfindung das Kontaktmittel stößelartig ausgebildet ist und durch den jeweiligen Durchbruch sich in Richtung des Kraftübertragungsbereiches erstreckt. Vorteilhafterweise kann das freie Ende des Kontaktmittels beabstandet zum Kraftübertragungsbereich sein, wobei der Abstand vorteilhafterweise gering ist. Erst bei einer entsprechenden Betätigung der Tasteneinheit erfolgt eine Kontaktierung des freien Endes des Kontaktmittels mit dem Kraftübertragungsbereich, wodurch über eine Verformung des Kraftübertragungsbereiches das Schaltelement betätigt wird. Ebenfalls ist es denkbar, dass bei einer unbetätigten Tasteneinheit bereits das freie Ende des Kontaktmittels den Kraftübertragungsbereich kontaktiert.

Der Träger weist mindestens eine Mulde auf, in der jeweils ein Durchbruch vorgesehen ist, wobei zumindest ein Teilbereich der Mulde eine Anschlagfunktion für das Tastenelement hat. Hierbei ist besonders vorteilhaft, dass die Mulde eines jeden Durchbruches eine spezielle Geometrie aufweist, die als Anschlag für das Tastenelement, insbesondere für die jeweilige Einzeltaste dient, um bei einem etwaig zu weiten Eindrücken des Tastenelementes Zerstörungen, insbesondere beim Schaltelement zu verhindern.

Zweckmäßigerweise trennt der Kraftübertragungsbereich das Innere des Gehäuses vom Außenbereich vollständig ab. Somit wird verhindert, dass jegliche Partikel, insbesondere Feuchtigkeit, Schmutz, etc. in den Innenraum der mobilen Vorrichtung eindringen können, in der beispielsweise störungsempfindliche Elektronikbauteile angeordnet sein können.

Bei einer möglichen Ausführungsform der Erfindung kann der Kraftübertragungsbereich laserdurchlässig ausgeführt sein, wobei die Tasteneinheit am Kraftübertragungsbereich laserverschweißt ist, insbesondere dass der Träger am Kraftübertragungsbereich laserverschweißt ist. Alternativ ist es denkbar, dass zumindest ein Bereich des Tastenelementes, der bis zum Kraftübertragungsbereich sich erstrecken kann, mit dem Kraftübertragungsbereich laserverschweißt ist. Vorteilhafterweise ist das Material des Kraftübertragungsbereiches für Laserstrahlung transparent ausgeführt. Der mit dem Kraftübertragungsbereich zu fügende Partner, insbesondere das Tastenelement oder der Träger weist ein Material auf, das für Laserstrahlung absorbierend ausgeführt ist. Bei dieser möglichen Ausgestaltung der Erfindung wird die Energie der Laserstrahlung durch den für die Laserstrahlung transparenten Fügepartner hin, insbesondere den Kraftübertragungsbereich, hindurch in die Fügeebene eingebracht, in der sich die zu verbindenden Fügeoberflächen der Fügepartner befinden. Die Fügeebene ist der Grenzschichtbereich zwischen den beiden Fügepartnern, hier der Kraftübertragungsbereich und der Träger bzw. das Tastenelement. Dort kann die elektromagnetische Energie vom absorbierenden Fügepartner nahezu verlustlos in Wärmeenergie umgewandelt werden. Die eingebrachte Energie führt zur Plastifizierung des absorbierenden Fügepartners. Über Wärmeleitung kann auch der transparente Fügepartner plastifiziert werden. Vorteilhafterweise entsteht ein stoffschlüssiger Kontakt zwischen den beiden Fügepartnern. Im Grenzschichtbereich entsteht vorteilhafterweise ein dünner Schmelzfilm von 10 bis 400 µm. Durch die berührungslose und lokale begrenzte Energieeintragung über die Laserstrahlung wird eine thermische Beschädigung der Fügepartner verhindert. Auch mechanische Belastungen werden vermieden, da die Fügepartner während der Einbringung der Energie und des Abkühlprozesses keine Relativbewegung zueinander erfahren. Die erzielbare stoffschlüssige Verbindung zeichnet sich durch ihre Dichtheit, Porenfreiheit und optischer Hochwertigkeit aus und liegt entsprechend der Werkstoffpaarungen der zu verbindenden Fügepartner im Bereich der Grundmaterialfestigkeit.

Es hat sich gezeigt, dass sich CO₂ -, Nd: YAG - und Diodenlaser zum Fügen der Fügepartner besonders eignen. Die Wellenlänge eines CO₂-Lasers bedingt sehr kurze optische Eindringtiefen in die Fügepartner, die für Diodenlaser transparent sind. Es hat sich gezeigt, dass die optische Eindringtiefe durch Großpigmentierung des Fügepartners gut eingestellt werden kann. Vorteilhafterweise zeichnet sich die Laserverschweißung durch eine im Vergleich zu anderen Verbindungstechniken, wie Kleben, bei der Dämpfe austreten können, vernachlässigbare Arbeitsplatzbelastung aus. Bei einem Einsatz von Hochleistungsdiodenlaser liegen die Emissionswellenlängen der Laserstrahlung in einem Bereich von ca. 800 bis 1.000 nm, welche beispielsweise durch optische Glasfasern transportiert werden können. Der Glasfasereinsatz ermöglicht die einfache Integration von Laser und Bearbeitungsoptik z. B. in einem Robotersystem, welches zum Einen das Gehäuse, die Tasteneinheit und/oder das Tastenelement in der Aufnahme des Gehäuses justieren kann und zum Anderen gleichzeitig die entsprechende Energie über die Laserstrahlung in die Fügepartner einbringt.

Denkbar ist, dass die Aufnahme als Vertiefung am Gehäuse ausgeführt ist, in der die Tasteneinheit sich befindet. Ferner kann vorteilhaft sein, dass die Oberfläche der Tasteneinheit nahezu bündig zur Oberfläche des Gehäuses verläuft. Hierdurch kann ein besonders zufriedenstellendes Haptikverhalten sichergestellt werden.

Der Montageaufwand der Gesamtanordnung kann dadurch vereinfacht werden, dass das Tastenelement klebefrei am Träger befestigt ist. Das Tastenelement wird lediglich über den Träger gespannt und/oder gestülpt. Anschließend befindet sich das Tastenelement auf dem Träger und ist an diesem unverrutschbar gehalten.

Ferner kann vorgesehen sein, dass das Gehäuse ein Oberteil und ein Unterteil aufweist, wobei die Tasteneinheit am Oberteil befestigt ist. Das Oberteil und das Unterteil können form- und/oder kraft- und/oder stoffschlüssig miteinander verbunden sein. Das Innere der mobilen Vorrichtung wird durch das Oberteil und das Unterteil zuverlässig abgeschlossen.

Vorteilhafterweise ist das Tastenelement derart elastisch ausgeführt, dass nach einer entsprechenden Aktivierung des Schaltelementes durch das Kontaktmittel das Tastenelement zurück in seine Ursprungslage elastisch sich verformt, wenn keine Kraft mehr auf das Tastenelement von außen ausgeübt wird. Die Einzeltasten des Tastenelementes, die nebeneinander angeordnet sein können, können über entsprechende Haptikelemente voneinander getrennt sein. Die Haptikelemente weisen vorteilhafterweise Materialeigenschaften auf, die zu den Einzeltasten unterschiedlich sind. Die Haptikelemente bilden vorteilhafterweise mit den Einzeltasten ein gemeinsames Bauteil, insbesondere hier das Tastenelement. Das Haptikelement kann beispielsweise als Rippe oder als eine nutartige Vertiefung zwischen den Einzeltasten ausgeführt sein.

Vorteilhafterweise weist das Tastenelement an seiner Außenseite einen Schutzlack auf. Dieser Schutzlack kann gegen Witterungsverhältnisse, Verkratzungen, etc. schützend wirken.

In einer vorteilhaften Ausführungsform der Erfindung ist die mobile Vorrichtung ein ID-Geber für eine schlüssellose Aktivierung einer Schließvorrichtung eines Kraftfahrzeuges. Hierbei kann der ID-Geber mit einem passiven Zugangsberechtigungssystems, insbesondere einem Zugangs- und Fahrberechtigungssystems des Kraftfahrzeuges kommunizieren. Beispielsweise kann das Kraftfahrzeug und der ID-Geber Codes miteinander austauschen, wobei die Kommunikation zwischen ID-Geber und dem Kraftfahrzeug über ein Funksignal erfolgen kann. Insbesondere werden die Signale induktiv ausgesandt. Vorteilhafterweise können die Signale aus Sicherheitsgründen kryptologisch verschlüsselt sein. Die genannte Kommunikation kann manuell über Tastendruck auf dem ID-Geber, insbesondere auf dem Tastenelement gestartet werden, alternativ ohne aktive Betätigung, also passiv gesteuert werden. Damit das Kraftfahrzeug auch genutzt werden kann, wenn die Elektronik innerhalb des ID-Gebers ausfallen sollte, weist der ID-Geber zweckmäßigerweise auch noch einen rein-mechanischen Notschlüssel auf.

Die Aufgabe wird ferner durch das Verfahren des unabhängigen Anspruches 15 gelöst. In dem abhängigen Verfahrensanspruch sind mögliche Ausführungsformen der Erfindung beansprucht.

Hierbei bezieht sich die Erfindung auf ein Verfahren zur Montage einer mobilen Vorrichtung zur Aktivierung mindestens eines Schaltelementes, das innerhalb eines Gehäuses angeordnet ist, mit einer Tasteneinheit die mindestens ein Kontaktmittel aufweist, wobei das Kontaktmittel zum Inneren des Gehäuses ausgerichtet ist, um das Schaltelement zu aktivieren, und einer an dem Gehäuse angeordneten Aufnahme, an der die Tasteneinheit befestigt ist. Besonders vorteilhaft ist hierbei, dass in einem ersten Schritt, ein flexibles Tastenelement auf einem Träger aufgespannt wird, wodurch sich die Tasteneinheit bildet. In einem weiteren Schritt wird die Tasteneinheit in die Aufnahme eingesetzt. Anschließend wird die Tasteneinheit laserverschweißt, wobei zumindest ein Teilbereich der Aufnahme laserdurchlässig ausgeführt ist. Neben der einfachen Montage der mobilen Vorrichtung zeichnet sich die mobile Vorrichtung dadurch aus, dass der Innenbereich des Gehäuses vom Außenbereich zuverlässig abgedichtet ist.

Weitere Vorteile, Merkmale und Einzelheiten der Erfindung ergeben sich aus der nachfolgenden Beschreibung, in der unter Bezugnahme auf die Zeichnungen die Erfindung dargestellt ist. Dabei können die in den Ansprüchen und in der Beschreibung erwähnten Merkmale für die erfindungsgemäße Vorrichtung und das erfindungsgemäße Verfahren einzeln für sich oder in beliebiger Kombination erfindungswesentlich sein. Es zeigen:
- Fig. 1: eine schematische Darstellung einer mobilen Vorrichtung, die als ID-Geber ausgeführt ist und die für eine schlüssellose Aktivierung einer Schließvorrichtung eines Kraftfahrzeuges dient,
- Fig. 2: eine mögliche Ausführungsvariante eines ID-Gebers gemäß Figur 1,
- Fig. 3: eine weitere Alternative des ID-Gebers gemäß Figur 1,
- Fig. 4: eine schematische Draufsicht auf einen Träger, der gemäß Figur 2 oder Figur 3 in der Tasteneinheit eingesetzt ist und
- Fig. 5: eine schematisch dargestellte Schnittansicht gemäß Figur 4.

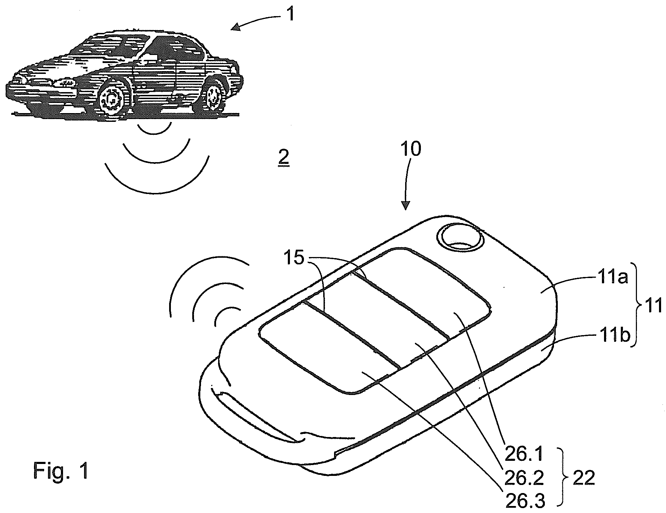

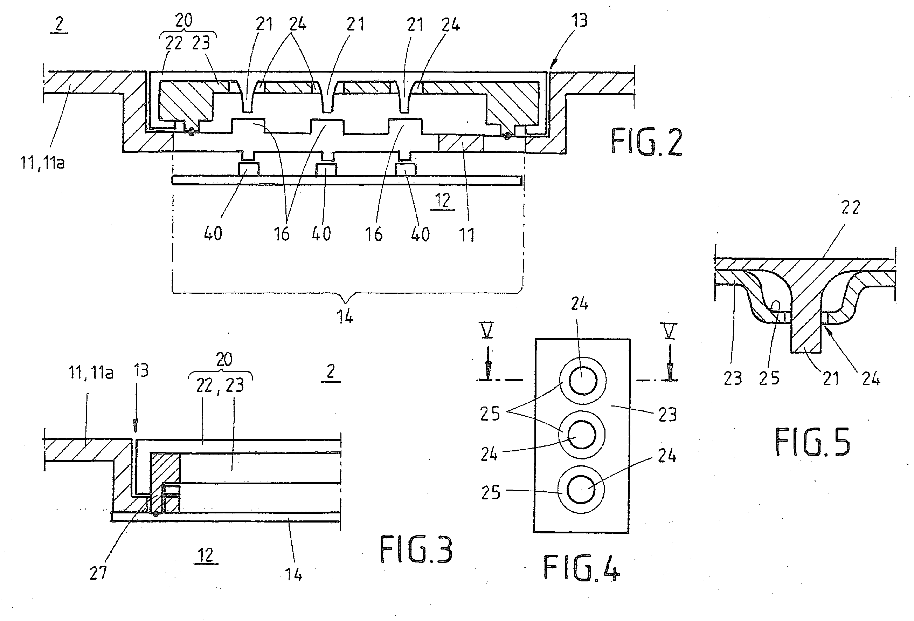

In Figur 1 ist eine mobile Vorrichtung 10 gezeigt, wobei die Vorrichtung 10 ein Gehäuse 11 aufweist, welches sich aus einem Oberteil 11a und einem Unterteil 11b zusammensetzt. Das Oberteil 11a und das Unterteil 11b sind Gehäuseschalen, die miteinander befestigt sind. Im Inneren des Gehäuses 11 ist ein Schaltelement 40 angeordnet, welches exemplarisch in Figur 2 und Figur 3 gezeigt ist. Dieses Schaltelement 40 kann über eine Tasteneinheit 20 aktiviert werden, indem der Benutzer auf die Tasteneinheit 20 drückt, worauf im Folgenden noch eingegangen wird. Die Tasteneinheit 20 ist durch ein Tastenelement 22 und einen Träger 23 gebildet, welche in Figur 2 und Figur 3 gezeigt sind. Das Tastenelement 22 umspannt den Träger 23. Hierbei ist das Tastenelement 22 an seinem Rand um den Träger 23 umgestülpt. Das Tastenelement 23 weist im vorliegenden Ausführungsbeispiel mehrere Einzeltasten 26.1, 26.2, 26.3 auf.

Die Tasteneinheit 20 ist gemäß Figur 2 und Figur 3 mit drei Kontaktmitteln 21 ausgeführt, wobei jedes Kontaktmittel 23 zum Inneren 12 des Gehäuses 11 ausgerichtet ist. Wenn der Benutzer auf die Tasteneinheit 20, insbesondere auf die jeweilige Einzeltaste 26 eine Kraft ausübt, erfolgt eine Verformung des Materials des Tastenelementes 22, wobei das Kontaktmittel 21 in Richtung des Innenraumes 12 bewegt wird.

Die Tasteneinheit 20 ist in einer Aufnahme 13 des Gehäuses 11 eingesetzt und befestigt. Hierbei weist die Aufnahme 13 einen Kraftübertragungsbereich 14 auf, der zwischen der Tasteneinheit 20 und den im Inneren 12 des Gehäuses 11 angeordneten Schaltelementen 40 verläuft. Hierbei ist das Innere 12 des Gehäuses 11 vollständig vom Außenbereich 2 der mobilen Vorrichtung 10 abgeschlossen. Das Gehäuse 11 und der Kraftübertragungsbereich 14 bilden ein gemeinsames, Zweikomponenten-Bauteil, wobei der Kraftübertragungsbereich 14 aus einem ersten Material ausgeführt ist und das Gehäuse 11 aus einem zweiten Material ausgeführt ist, wobei das erste Material einen geringeren mechanischen Widerstand als das zweite Material aufweist. Hierbei weist der Kraftübertragungsbereich eine Weichkomponente in seinem ersten Material auf. Der restliche Gehäusebereich ist hingegen härter ausgeführt.

Gemäß Figur 4 und Figur 5 weist der Träger 23 mehrere Durchbrüche 24 auf, durch die jeweils ein Kontaktmittel 21 sich erstrecken. Hierbei ist der Träger 23 mit jeweils einer Mulde 25 an jedem Durchbruch 24 ausgebildet. Die Mulde 25 weist eine gekrümmte Geometrie auf, wobei bei einem unbetätigten Tastenelement 22 eine Beabstandung zum gekrümmten Bereich der Mulde 25 besteht. Wenn nun das Tastenelement 22 auf der jeweiligen Einzeltaste 26 betätigt wird, erfolgt eine Verformung, sodass das Kontaktmittel 21 sich in Richtung Kraftübertragungsbereich 14 bzw. zum Schaltelement 40 bewegt. Ab einem definierten Bewegungshub der Einzeltaste 26 erfolgt eine Kontaktierung der Einzeltaste 26 mit dem gekrümmten Bereich der Mulde 25, die als Anschlag dient. Hierdurch kann wirkungsvoll ein weiteres Eindrücken der Einzeltaste 26 verhindert werden, sodass etwaige Zerstörungen, insbesondere am Schaltelement 40 ausgeschlossen werden können.

Gemäß Figur 2 ist das flexible Tastenelement 20 am Träger 23 aufgespannt. Der wesentliche Unterschied in der Figur 3 ist, dass der Träger 23 an seiner Seite zumindest einen Vorsprung 27 aufweist, der durch eine Öffnung des Tastenelementes 22 sich erstreckt. Hierdurch ist eine weitere Befestigungswirkung des Tastenelementes 20 am Träger 23 erzielbar.

Die Tasteneinheit 20 gemäß aller Ausführungsbeispiele ist am Kraftübertragungsbereich 14 des Gehäuses 11 laserverschweißt. Hierbei ist das Material des Kraftübertragungsbereiches 14 laserdurchlässig ausgeführt. Die miteinander zu verschweißenden Fügepartner sind somit zum Einen der Kraftübertragungsbereich 14 und zum Anderen der Träger 23. Gemäß Figur 3 wird der Vorsprung 27 des Trägers 23 mit dem Kraftübertragungsbereich 14 laserverschweißt.

Wie Figur 2 und Figur 3 verdeutlichen, ist die Aufnahme 13 als Vertiefung am Gehäuse 11 ausgeführt, in der die Tasteneinheit 20 sich befindet. Hierbei ist die Oberfläche der Tasteneinheit 20 nahezu bündig zur Oberfläche des Gehäuses 11 angeordnet.

Wie Figur 2 exemplarisch zeigt, kann der Kraftübertragungsbereich 14 mit diversen Ausbuchtungen 16 ausgeführt sein, die in Richtung des Trägers 23 bzw. des jeweiligen Kontaktmittels 21 vorsprungartig sich erstrecken. Unterhalb des Kraftübertragungsbereiches 14 befinden sich die Schaltelemente 40. Jedes Schaltelement 40 ist einer definierten Einzeltaste 26 zugeordnet. Die Schaltelemente 40 können mechanische Schalter, elektromechanische Schalter, etc. sein. Die Schaltelemente 40 sind auf einer nicht dargestellten Platine (ohne Bezugszeichen) im Inneren 12 des Gehäuses 11 angeordnet. Über die Aktivierung des Schaltelementes 40 kann ein Signal ausgelöst werden, wodurch wiederum unterschiedliche Funktionen gestartet werden können, beispielsweise gemäß Figur 1 ein Verriegelungsvorgang oder ein Entriegelungsvorgang einer Schließvorrichtung in einem Kraftfahrzeug 1.

Gemäß Figur 1 sind zwischen den Einzeltasten 26 jeweils ein Haptikelement 15 vorgesehen, welches derart in seiner Materialeigenschaft unterschiedlich zu den Einzeltasten 26 ausgeführt ist, dass ein zufriedenstellendes Haptikvermögen und Haptikverhalten der jeweiligen Einzeltaste 26 dem Benutzer zur Verfügung gestellt wird. Insbesondere bewirkt das Haptikelement 15, dass nach einer entsprechenden Betätigung des Benutzers die Einzeltaste 26 in ihre ursprüngliche Position sich zurückbewegt. Die Einzeltasten 26 bilden ein Tastenfeld, wobei die Einzeltasten 26 mit den Haptikelementen 15 ein gemeinsames, monolithisches Bauteil bilden, welches am Träger 23 gemäß Figur 2 oder Figur 3 befestigt ist.

Während der Montage der mobilen Vorrichtung 10 wird in einem ersten Schritt das Tastenelement 10 am Träger 23, der aus einem härteren Material besteht als das Tastenelement 22, aufgespannt, sodass das Tastenelement 22 zuverlässig am Träger 23 befestigt ist. Die Befestigung des Tastenelementes 22 erfolgt hierbei klebefrei am Träger 23. Anschließend wird die Tasteneinheit 20 in die Aufnahme 13 eingesetzt. In einem nächsten Schritt erfolgt die Laserverschweißung des Trägers 23, insbesondere des Vorsprunges 27 mit dem Kraftübertragungsbereich 14.

### Bezuaszeichenliste

- 1: Kraftfahrzeug
- 2: Außenbereich

- 10: mobile Vorrichtung, ID-Geber
- 11: Gehäuse
- 11a: Oberteil
- 11b: Unterteil
- 12: Innere des Gehäuses, Innenraum
- 13: Aufnahme
- 14: Kraftübertragungsbereich
- 15: Haptikelement
- 16: Ausbuchtung

- 20: Tasteneinheit
- 21: Kontaktmittel
- 22: Tastenelement
- 23: Träger
- 24: Durchbruch
- 25: Mulde
- 26: Einzeltasten
- 26.1: Einzeltasten
- 26.2: Einzeltasten
- 26.3: Einzeltasten
- 27: Vorsprung

- 40: Schaltelement

## Patentansprüche

1. Mobile Vorrichtung (10) zur Aktivierung mindestens eines Schaltelementes (40), das innerhalb eines Gehäuses (11,12) angeordnet ist, mit
einer Tasteneinheit (20), die mindestens ein Kontaktmittel (21) aufweist,
wobei das Kontaktmittel (21) zum Innern (12) des Gehäuses (11) ausgerichtet ist, um das Schaltelement (40) zu aktivieren, und
einer an dem Gehäuse (11) angeordneten Aufnahme (13), an der die Tasteneinheit (20) befestigt ist,
**dadurch gekennzeichnet,**
**dass** die Aufnahme (13) einen Kraftübertragungsbereich (14) aufweist, der zwischen der Tasteneinheit (20) und dem Schaltelement (40) derart angeordnet ist, dass das Innere (12) des Gehäuses (11) vom Außenbereich (2) geschützt ist, wobei die Tasteneinheit (20) zumindest durch ein flexibles und/oder elastisches Tastenelement (22) und einen Träger (23) gebildet ist, der zumindest teilweise durch das flexible Tastenelement (22) umfasst ist,
wobei der Träger (23) mindestens eine Mulde (25) aufweist, in der jeweils ein Durchbruch (24) vorgesehen ist, wobei zumindest ein Teilbereich der Mulde (25) eine Anschlagfunktion für das Tastenelement (22) hat.

2. Mobile Vorrichtung (10) nach Anspruch 1,
**dadurch gekennzeichnet,**
**dass** das Gehäuse (11) und der Kraftübertragungsbereich (14) ein gemeinsames, Zweikomponenten-Bauteil bilden.

3. Mobile Vorrichtung (10) nach Anspruch 1 oder 2,
**dadurch gekennzeichnet,**
**dass** der Kraftübertragungsbereich (14) aus einem ersten Material ausgeführt ist und das Gehäuse (11) aus einem zweiten Material ausgeführt ist, wobei das erste Material einen geringeren mechanischen Widerstand hat als das zweite Material.

4. Mobile Vorrichtung (10) nach einem der vorhergehenden Ansprüche,
**dadurch gekennzeichnet,**
**dass** das Tastenelement (22) am Träger (23) aufgespannt ist, insbesondere dass das Tastenelement (22) strumpfartig am Träger (23) aufgezogen und/oder aufgestülpt ist.

5. Mobile Vorrichtung (10) nach einem der vorhergehenden Ansprüche,
**dadurch gekennzeichnet,**
**dass** das Tastenelement (22) mit mindestens einem Kontaktmittel (21) ausgeführt ist, das durch einen Durchbruch (24) des Trägers (23) sich erstreckt, wobei insbesondere mehrere Kontaktmittel (21) vorgesehen sind, die durch jeweils unterschiedliche Durchbrüche (24) des Trägers (23) sich erstrecken.

6. Mobile Vorrichtung (10) nach einem der vorhergehenden Ansprüche,
**dadurch gekennzeichnet,**
**dass** der Kraftübertragungsbereich das Innere (12) des Gehäuses (11) vom Außenbereich (2) vollständig trennt.

7. Mobile Vorrichtung (10) nach einem der vorhergehenden Ansprüche,
**dadurch gekennzeichnet,**
**dass** der Kraftübertragungsbereich (14) laserdurchlässig ausgeführt ist, wobei die Tasteneinheit (20) am Kraftübertragungsbereich (14) laserverschweißt ist, insbesondere dass der Träger (23) am Kraftübertragungsbereich (14) laserverschweißt ist.

8. Mobile Vorrichtung (10) nach einem der vorhergehenden Ansprüche,
**dadurch gekennzeichnet,**
**dass** die Aufnahme (13) als Vertiefung am Gehäuse (11) ausgeführt ist, in der die Tasteneinheit (20) sich befindet.

9. Mobile Vorrichtung (10) nach einem der vorhergehenden Ansprüche,
**dadurch gekennzeichnet,**
**dass** die Oberfläche der Tasteneinheit (20) nahezu bündig zur Oberfläche des Gehäuses (11) verläuft.

10. Mobile Vorrichtung (10) nach einem der vorhergehenden Ansprüche,
**dadurch gekennzeichnet,**
**dass** das Tastenelement (22) klebefrei am Träger (23) befestigt ist.

11. Mobile Vorrichtung (10) nach einem der vorhergehenden Ansprüche,
**dadurch gekennzeichnet,**
**dass** das Gehäuse (11) ein Oberteil (11a) und ein Unterteil (11b) aufweist, wobei die Tasteneinheit (20) am Oberteil (11a) befestigt ist.

12. Mobile Vorrichtung (10) nach einem der vorhergehenden Ansprüche,
**dadurch gekennzeichnet,**
**dass** die Vorrichtung (10) ein ID-Geber für eine schlüssellose Aktivierung einer Schließvorrichtung eines Kraftfahrzeuges (1) ist.

13. Verfahren zur Montage einer mobilen Vorrichtung (10) zur Aktivierung mindestens eines Schaltelementes (40), das innerhalb eines Gehäuses (11) angeordnet ist, mit einer Tasteneinheit (20), die mindestens ein Kontaktmittel (21) aufweist, wobei das Kontaktmittel (21) zum Inneren (12) des Gehäuses (11) ausgerichtet ist, um das Schaltelement (40) zu aktivieren, und
einer an dem Gehäuse (11) angeordneten Aufnahme (13), an der die Tasteneinheit (20) befestigt ist,
**dadurch gekennzeichnet,**
**dass**
(1) ein flexibles Tastenelement (22) auf einem Träger (23) aufgespannt wird, wodurch sich die Tasteneinheit (20) bildet,
(2) die Tasteneinheit (20) in die Aufnahme (13) eingesetzt wird, und
(3) die Tasteneinheit (20) in der Aufnahme (13) laserverschweißt wird, wobei zumindest ein Teilbereich der Aufnahme (13) laserdurchlässig ausgeführt ist, wobei die Tasteneinheit (20) zumindest durch ein flexibles und/oder elastisches Tastenelement (22) und einen Träger (23) gebildet wird, der zumindest teilweise durch das flexible Tastenelement (22) umfasst wird, wobei der Träger (23) mindestens eine Mulde (25) aufweist, in der jeweils ein Durchbruch (24) vorgesehen ist, wobei zumindest ein Teilbereich der Mulde (25) eine Anschlagfunktion für das Tastenelement (22) hat.

14. Verfahren nach Anspruch 13, wobei die mobile Vorrichtung (10) gemäß einem der Ansprüche 1 bis 12 ausgeführt ist.

## Claims

1. A mobile device (10) for activating at least one switching element (40) arranged inside of a housing (11, 12), with
a pushbutton unit (20), which has at least one contact means (21), wherein the contact means (21) is aligned toward the interior (12) of the housing (11) so as to activate the switching element (40), and
a receptacle (13) that is arranged on the housing (11), and has the pushbutton unit (20) fastened to it,
**characterized in that**
the receptacle (13) has a force transmission area (14) arranged between the pushbutton unit (20) and the switching element (40) in such a way as to protect the interior (12) of the housing (11) against the exterior area (2), wherein the pushbutton unit (20) is formed at least by a flexible and/or elastic pushbutton element (22) and a carrier (23), which is at least partially enveloped by the flexible pushbutton element (22), wherein the carrier (23) has at least one trough (25) in which a respective aperture (24) is provided, wherein at least one partial area of the trough (25) has a stop function for the pushbutton element (22).

2. The mobile device (10) according to claim 1,
**characterized in that**
the housing (11) and force transmission area (14) comprise a shared, two-component part.

3. The mobile device (10) according to claim 1 or 2, **characterized in that**
the force transmission area (14) is comprised of a first material, and the housing (11) is comprised of a second material, wherein the first material has a lower mechanical resistance than the second material.

4. The mobile device (10) according to one of the preceding claims,
**characterized in that**
the pushbutton element (22) is clamped onto the carrier (23), in particular that the pushbutton element (22) is slipped and/or put onto the carrier (23) like a stocking.

5. The mobile device (10) according to one of the preceding claims,
**characterized in that**
the pushbutton element (22) is designed with at least one contact means (21) that extends through an aperture (24) of the carrier (23), wherein in particular several contact means (21) are provided that extend through respectively different apertures (24) of the carrier (23).

6. The mobile device (10) according to one of the preceding claims,
**characterized in that**
the force transmission area completely separates the interior (12) of the housing (11) from the exterior area (2).

7. The mobile device (10) according to one of the preceding claims,
**characterized in that**
the force transmission area (14) has a laser-permeable design, wherein the pushbutton unit (20) is laser welded at the force transmission area (14), in particular that the carrier (23) is laser welded at the force transmission area (14).

8. The mobile device (10) according to one of the preceding claims,
**characterized in that**
the receptacle (13) is designed as a depression on the housing (11), in which the pushbutton unit (20) is located.

9. The mobile device (10) according to one of the preceding claims,
**characterized in that**
the surface of the pushbutton unit (20) runs nearly flush with the surface of the housing (11).

10. The mobile device (10) according to one of the preceding claims,
**characterized in that**
the pushbutton element (22) is non-adhesively fastened to the carrier (23).

11. The mobile device (10) according to one of the preceding claims,
**characterized in that**
the housing (11) has an upper part (11a) and a lower part (11b), wherein the pushbutton unit (20) is fastened to the upper part (11a).

12. The mobile device (10) according to one of the preceding claims,
**characterized in that**
the device (10) is an ID transmitter for the keyless activation of a closing device of a motor vehicle (1).

13. A method for assembling a mobile device (10) for activating at least one switching element (40) arranged inside of a housing (11), with
a pushbutton unit (20), which has at least one contact means (21), wherein the contact means (21) is aligned toward the interior (12) of the housing (11) so as to activate the switching element (40), and
a receptacle (13) that is arranged on the housing (11), and has the pushbutton unit (20) fastened to it,
**characterized in that**
(1) a flexible pushbutton element (22) is clamped onto a carrier (23), thereby forming the pushbutton unit (20);
(2) the pushbutton unit (20) is placed in the receptacle (13), and
(3) the pushbutton unit (20) is laser welded in the receptacle, wherein at least a partial area of the receptacle (13) has a laser-permeable design, wherein the pushbutton unit (20) is comprised of at least one flexible and/or elastic pushbutton element (22) and a carrier (23), which is at least partially enveloped by the flexible pushbutton element (22), wherein the carrier (23) has at least one trough (25) in which a respective aperture (24) is provided, wherein at least one partial area of the trough (25) has a stop function for the pushbutton element (22).

14. The method according to claim 13, wherein the mobile device (10) is designed according to one of claims 1 to 12.

## Revendications

1. Dispositif mobile (10) pour l'activation d'au moins un élément de commutation (40) disposé à l'intérieur d'un boîtier (11, 12), comprenant :
une unité de bouton (20) présentant au moins un moyen de contact (21), dans lequel le moyen de contact (21) est orienté vers l'intérieur (12) du boîtier (11) pour l'activation de l'élément de commutation (40), et
un logement (13) disposé sur le boîtier (11), sur lequel est fixée l'unité de bouton (20),
**caractérisé en ce que**
le logement (13) présente une région de transmission de force (14) agencée de telle façon entre l'unité de bouton (20) et l'élément de commutation (40), que l'intérieur (12) du boîtier (11) est protégé par rapport à la région extérieure (2), l'unité de bouton (20) étant formée par au moins un élément de bouton souple et/ou élastique (22) et un support (23), lequel est au moins partiellement entouré par l'élément de bouton souple (22), le support (23) présentant au moins un creux (25) dans laquelle est prévue respectivement au moins une percée (24), où au moins une région partielle du creux (25) possède une fonction de blocage pour l'élément de bouton (22).

2. Dispositif mobile (10) selon la revendication 1, **caractérisé en ce que**
le boîtier (11) et la région de transmission de force (14) forment un bloc commun à deux composants.

3. Dispositif mobile (10) selon la revendication 1 ou 2,
**caractérisé en ce que**
la région de transmission de force (14) est constituée d'un premier matériau et le boîtier (11) est constitué d'un deuxième matériau, le premier matériau possédant une résistance mécanique inférieure à celle du deuxième matériau.

4. Dispositif mobile (10) selon l'une des revendications précédentes,
**caractérisé en ce que**
l'élément de bouton (22) est tendu sur le support (23), en particulier **en ce que** l'élément de bouton (22) est enfilé et/ou enfoncé comme un bas sur le support.

5. Dispositif mobile (10) selon l'une des revendications précédentes,
**caractérisé en ce que**
l'élément de bouton (22) est conçu avec au moins un moyen de contact (21), lequel s'étend à travers une percée (24) du support (23), plusieurs moyens de contact (21) étant prévus en particulier, lesquels s'étendent respectivement à travers des percées (24) distinctes du support (23).

6. Dispositif mobile (10) selon l'une des revendications précédentes,
**caractérisé en ce que**
la région de transmission de force (14) sépare complètement l'intérieur (12) du boîtier (11) de la région extérieure (2).

7. Dispositif mobile (10) selon l'une des revendications précédentes,
**caractérisé en ce que**
la région de transmission de force (14) est conçue perméable au laser, l'unité de bouton (20) étant soudée au laser sur la région de transmission de force (14), en particulier **en ce que** le support (23) est soudé au laser sur la région de transmission de force (14).

8. Dispositif mobile (10) selon l'une des revendications précédentes,
**caractérisé en ce que**
le logement (13) est conçu comme un renfoncement dans le boîtier (11), dans lequel se trouve l'unité de bouton (20).

9. Dispositif mobile (10) selon l'une des revendications précédentes,
**caractérisé en ce que**
la surface de l'unité de bouton (20) s'étend quasiment en affleurement avec la surface du boîtier (11).

10. Dispositif mobile (10) selon l'une des revendications précédentes,
**caractérisé en ce que**
l'élément de bouton (22) est fixé sans colle au support (23).

11. Dispositif mobile (10) selon l'une des revendications précédentes,
**caractérisé en ce que**
le boîtier (11) comporte une partie supérieure (11a) et une partie inférieure (11b), l'unité de bouton (20) étant fixée à la partie supérieure (11a).

12. Dispositif mobile (10) selon l'une des revendications précédentes,
**caractérisé en ce que**
le dispositif (10) est un indicateur d'identification pour une activation sans clé d'un dispositif de fermeture d'un véhicule automobile (1).

13. Procédé pour le montage d'un transmetteur mobile (10) pour l'activation d'au moins un élément de commutation (40) disposé à l'intérieur d'un boîtier (11), comprenant
une unité de bouton (20) présentant au moins un moyen de contact (21), dans lequel le moyen de contact (21) est orienté vers l'intérieur (12) du boîtier (11) pour l'activation de l'élément de commutation (40), et
un logement (13) disposé sur le boîtier (11), sur lequel est fixée l'unité de bouton (20),
**caractérisé en ce que**
(1) un élément de bouton souple (22) est tendu sur un support (23), formant ainsi l'unité de bouton (20),
(2) l'unité de bouton (20) est insérée dans le logement (13), et
(3) l'unité de bouton (20) est soudée au laser dans le logement (13), au moins une région partielle du logement (13) étant conçue perméable au laser, l'unité de bouton (20) étant formée au moins par un élément de bouton souple et/ou élastique (22) et un support (23) entouré au moins partiellement par l'élément de bouton souple (22), le support (23) comportant au moins un creux (25) dans lequel est prévue respectivement une percée (24), au moins une région partielle du creux (25) possédant une fonction de blocage pour l'élément de bouton (22).

14. Procédé selon la revendication 13, dans lequel le dispositif mobile (10) est conçu selon l'une des revendications 1 à 12.
